(19) Europäisches Patentamt / European Patent Office / Office européen des brevets

(11) **EP 1 690 844 B1**

(12) **EUROPEAN PATENT SPECIFICATION**

(45) Date of publication and mention
of the grant of the patent:
**21.11.2012 Bulletin 2012/47**

(51) Int Cl.:
*B32B 18/00* (2006.01)     *C04B 35/491* (2006.01)
*C04B 35/626* (2006.01)     *H01L 41/083* (2006.01)
*H01L 41/187* (2006.01)     *C04B 35/493* (2006.01)

(21) Application number: **04799862.0**

(22) Date of filing: **22.11.2004**

(86) International application number:
**PCT/JP2004/017660**

(87) International publication number:
**WO 2005/051862 (09.06.2005 Gazette 2005/23)**

(54) **PIEZOELECTRIC CERAMIC AND LAMINATED PIEZOELECTRIC DEVICE**

PIEZOELEKTRISCHE KERAMIK UND LAMINIERTE PIEZOELEKTRISCHE VORRICHTUNG

CERAMIQUE PIEZO-ELECTRIQUE ET DISPOSITIF PIEZO-ELECTRIQUE LAMINE

(84) Designated Contracting States:
**DE FR GB**

(30) Priority: **26.11.2003 JP 2003396133**
**24.12.2003 JP 2003426895**
**27.05.2004 JP 2004158441**

(43) Date of publication of application:
**16.08.2006 Bulletin 2006/33**

(73) Proprietor: **KYOCERA CORPORATION**
**Kyoto-shi,**
**Kyoto 612-8501 (JP)**

(72) Inventors:
• **KAWAMOTO, Tomohiro**
**Kokubu-shi, Kagoshima 8994312 (JP)**
• **UCHIMURA, Hideki**
**Kokubu-shi, Kagoshima 8994312 (JP)**

(74) Representative: **Price, Nigel John King et al**
**J A Kemp**
**14 South Square**
**Gray's Inn**
**London WC1R 5JJ (GB)**

(56) References cited:
**EP-A- 1 387 417     EP-A- 1 686 633**
**JP-A- 9 278 535     JP-A- 2001 316 179**
**JP-A- 2002 293 625     JP-A- 2002 299 710**
**JP-A- 2003 055 045     JP-A- 2003 201 174**
**JP-A- 2004 111 895     US-A- 5 648 012**

EP 1 690 844 B1

**Description**

(Technical Field)

The present invention relates to a piezoelectric ceramic and, more specifically, to a piezoelectric ceramic suited for a laminated piezoelectric actuator, a piezoelectric transformer and an ink-jet printer head.

(Background Art)

A co-fired laminated piezoelectric element having internal electrodes has heretofore been known, and has been applied to a laminated piezoelectric actuator, a piezoelectric transformer and an ink-jet printer head. The co-fired laminated piezoelectric element is fabricated by co-firing a laminate obtained by alternately laminating ceramic green sheets (that serve as piezoelectric layers) and conducting patterns (that serve as internal electrode layers), and by forming external electrodes thereon, and produces a predetermined displacement by utilizing a counter-piezoelectric effect possessed by the piezoelectric material.

As the piezoelectric ceramic that constitutes piezoelectric layers of the laminated piezoelectric element, there has been widely used a perovskite composite oxide having an $ABO_3$ composition. For example, JP-A-2002-293625 (prior art (a)) discloses a piezoelectric ceramic comprising a perovskite composite oxide containing Pb as an A-site element, and Zr and Ti as B-site elements, wherein the A-site element (Pb) is partly substituted with Ca, Sr and Ba, the B-site elements (Zr, Ti) are partly substituted with a rare earth element such as Dy and by W, and the A/B site ratio is set to be 0.955 to 0.99, in an attempt to improve a piezoelectric distortion constant and a Curie point. Further, JP-A-2002-299710 (prior art (b)) discloses a piezoelectric ceramic comprising a perovskite composite oxide wherein the B-site elements (Zr, Ti) are partly substituted with W, Zn and Nb, enabling the firing to be conducted at a low temperature due to being substituted with Zn and Nb, and, further, making it possible to co-fire the internal electrodes having an Ag ratio of not smaller than 90% by mass.

The piezoelectric ceramics disclosed in the above prior arts (a) and (b) are fabricated by, first, weighing the starting powders of PbO, $ZrO_2$ and $TiO_2$ in predetermined amounts, wet-mixing these powders by using a ball mill or the like, drying the mixture, calcining the mixture under a predetermined temperature condition, milling the calcined body again by using the ball mill or the like to obtain a desired grain size distribution, forming a desired molded body by using a slurry obtained by adding an organic binder or an organic solvent to the powder of the calcined body, and firing the molded body.

However, the piezoelectric ceramic disclosed in the prior art (a) must be fired at a temperature of as very high as 1150°C to enhance the piezoelectric characteristics, making it difficult to conduct the firing at a temperature of as low as, for example, 1000°C or lower. That is, when the firing is conducted at a temperature of 1000°C or lower, the Curie point and the piezoelectric distortion constant become so low that desired piezoelectric displacement characteristics are not obtained. Further, a high firing temperature makes it difficult to co-fire the internal electrode layers in combination with the piezoelectric ceramic, which is disadvantageous from the standpoint of lowering the cost.

The piezoelectric ceramic disclosed in the prior art (b) which contains subcomponents such as Zn and Nb, can be co-fired together with the internal electrode layers that contain not less than 90% by mass of Ag causing, however, the Curie temperature to decrease with an increase in the amount of addition of Zn and Nb. Therefore, the thus obtained laminated piezoelectric element is accompanied by a problem of low durability and low reliability against high temperatures.

As described above, none of the conventional piezoelectric ceramics simultaneously satisfy the assignments of high piezoelectric characteristics and firing at a low temperature.

(Disclosure of the Invention)

EP 1,387,417 A2 discloses a piezoelectric part with a piezoelectric ceramic body formed of a perovskite compound oxide expressed by the general formula of $ABO_3$. A ceramic powder raw material is made with an average valence of the B-site between 4.000 and 4.009.

It is, therefore, an object of the present invention to provide a piezoelectric ceramic that can be fired at a low temperature, has a high Curie temperature and a high piezoelectric distortion constant, as well as excellent durability and reliability against high temperatures.

Another object of the present invention is to provide a method of producing a piezoelectric ceramic having the above-mentioned characteristics and a laminated piezoelectric element using the above piezoelectric ceramic.

According to the present invention, there is provided a laminated piezoelectric element and a method of manufacturing the same as defined in the claims.

In the present invention, the average valency of element species constituting the B-site is found as described below (the valency stands for a value of ionization stemming from a general balance of electrons of elements in the periodic table). For example, when there are contained 0.4 mols of Zr (valency of +4), 0.4 mols of Ti (valency of +4), 0.1 mol of W (valency of +6) and 0.1 mol of Yb (valency of +3) per mol of the total amount of element species constituting the B-site, an average valency becomes 4 x 0.4 + 4 x 0.4 + 6 x 0.1 + 3 x 0.1 = 4.1.

It is desired that the above piezoelectric ceramic contains the constituent element species of the perovskite composite oxide in such amounts that satisfy the molar ratios expressed by the following formula,

$$[Pb_{y-a}M^1{}_a]\cdot[M^2{}_bM^3{}_c(Zr_{1-x}Ti_x)_{1-b-c}]\cdot O_{3+\alpha}$$

wherein $M^1$ is at least one kind of element species constituting the A-site selected from the group consisting of Ca, Sr, Ba, Nd and Li,

$M^2$ is at least one kind of element species constituting the B-site selected from the group consisting of Y, Dy, Ho, Er, Tm, Yb and Lu,

$M^3$ is at least one kind of element species constituting the B-site selected from the group consisting of W, Nb and Sb, and

a, b, c, x, y and are expressed by the following conditions:

$$0.98 \leqq y \leqq 1.01$$

$$0.01 \leqq a \leqq 0.1$$

$$0.005 \leqq b \leqq 0.025$$

$$0.005 \leqq c \leqq 0.015$$

$$0.45 \leqq x \leqq 0.55$$

$$-0.03 \leqq \alpha \leqq 0.02.$$

It is desired that the piezoelectric ceramic has an average grain size in a range of 1 to 6 $\mu$m.

In the piezoelectric ceramic of the present invention, the average valency of the element species constituting the B-site in the perovskite composite oxide is set to lie in a particular range. Therefore, the piezoelectric ceramic exhibits a high Curie temperature and a high effective piezoelectric distortion constant, as well as excellent durability and reliability against high temperatures. Besides, the piezoelectric ceramic can be obtained through the filing at a low temperature (950 to 1000°C).

According to an unclaimed example, there is provided a method of producing a piezoelectric ceramic comprising the steps of:

preparing a starting powder for a perovskite composite oxide which comprises a starting compound for the A-site and starting compounds for the B-site of the perovskite composite oxide, wherein at least a Pb oxide is contained as the starting compound for the A-site and at least a Zr oxide and a Ti oxide are contained as the starting compounds for the B-site, the starting compounds for the B-site being contained in such amounts that when the total amount of the element species constituting the B-site is calculated to be one mol, an average valency of the element species of the B-site is 4.002 to 4.009;

calcining the mixed powder at not higher than 900° C;

preparing a slurry for molding by adding an organic binder to a calcined body obtained through the above step of calcining, and preparing a molded body of a predetermined shape by using the slurry; and

firing the molded body.

In this method of producing a piezoelectric ceramic, it is desired that:

(1) The starting powder for the perovskite composite oxide has been adjusted to be a fine powder having an average grain size $D_{50}$ of not larger than 0.8 μm;
(2) The calcined body has an average grain size $D_{50}$ of not larger than 0.8 μm;
(3) $Pb_3O_4$ is used as the Pb oxide; and
(4) The firing is conducted at 950 to 1000°C.

In the production method of the present invention, the starting powder (mixed powder of a compound powder containing an element species constituting the A-site and a compound powder containing element species constituting the B-site) is so adjusted that an average valency of element species constituting the B-site lies in a predetermined range. Upon effecting the firing after calcined at a temperature as low as 900°C or lower, therefore, there is obtained a piezoelectric ceramic having high piezoelectric characteristics. Besides, even when the firing is effected at a low temperature (950 to 1000° C), the piezoelectric characteristics are not deteriorated.

According to the present invention, the laminated piezoelectric element has the piezoelectric layers that are formed by using the piezoelectric ceramic featuring excellent piezoelectric characteristics, and can be produced by co-firing the piezoelectric layers and the internal electrode layers having a high Ag ratio, offering a great advantage even from the standpoint of decreasing the cost.

In the laminated piezoelectric element, further, the piezoelectric layers are subjected to the polarization treatment. Here, the piezoelectric layers have been treated in an electric field in a no-load state prior to being subjected to the polarization treatment. Through the treatment in the electric field, gaps are partly formed in the interfaces among the piezoelectric layers and the internal electrode layers. Formation of the gaps helps increase the amount of displacement of the piezoelectric layers which are in contact with the internal electrode layers. As a result, it is made possible to very greatly increase the amount of displacement of the laminated piezoelectric element.

(Brief Description of the Drawings)

Fig. 1 is a schematic sectional view of an exemplary laminated piezoelectric element;
Fig. 2 is a view illustrating, on an enlarged scale, a major portion of the laminated piezoelectric element of Fig. 1;
Fig. 3 is a view illustrating an injection device using the laminated piezoelectric element of Fig. 1; and
Fig. 4 is a schematic sectional view of the laminated piezoelectric element according to an embodiment of the present invention.

(Best Mode for Carrying Out the Invention)

(Piezoelectric Ceramic)

The piezoelectric ceramic of the present invention comprises a perovskite composite oxide of an AB03 composition, and contains Pb as an element species that constitutes the A-site and contains Zr and Ti as element species that constitute the B-site. That is, in the above piezoelectric ceramic, the peroviskite composite oxide particles represented by the following formula (1) are precipitated as main crystals,

$$(Pb, Q_A)(Zr, Ti, Q_B)O_3 \qquad (1)$$

wherein $Q_A$ is an element species constituting the A-site other than Pb,
$Q_B$ is an element species constituting the B-site Other than Zr and Ti, and
$Q_A$ and $Q_B$ may not be present.

In the piezoelectric ceramic of the present invention, element species constituting the B-site of the perovskite composite oxide are contained in such amounts that an average valency thereof is in a range of 4.002 to 4.009 and, preferably, 4.003 to 4.007. Therefore, the piezoelectric ceramic of the invention exhibits a high Curie temperature and a high effective piezoelectric distortion constant, as well as excellent durability and reliability against high temperatures. For example, when the average valency of element species constituting the B-site lies outside the above range, the effective piezoelectric distortion constant drops and the Curie temperature decreases, too, when the piezoelectric ceramic is produced through the firing at a low temperature as will be described later. Though it has not yet been clarified in the present invention why the above excellent characteristics are exhibited upon setting the average valency of element specifies constituting the B-site to lie in the above range, it is presumed that the above element species contribute to forming the B-site even when the firing is conducted at a low temperature and there is formed an ideal perovskite composite oxide represented by the above formula.

From the standpoint of obtaining a piezoelectric ceramic having a high Curie temperature and a high effective piezoelectric distortion constant, further, it is desired that an average valency of the element species constituting the A-site is in a range of 1.99 to 2.01.

Under a condition where the average valency of element species constituting the B-site is within the above range, further, it is desired that the piezoelectric ceramic of the present invention contains the constituent element species of the perovskite composite oxide in such amounts that satisfy the molar ratios expressed by the following formula (2),

$$[Pb_{y-a}M^1_a] \cdot [M^2_b M^3_c (Zr_{1-x}Ti_x)_{1-b-c}] \cdot O_{3+\alpha} \qquad (2)$$

wherein $M^1$ is at least one kind of element species constituting the A-site selected from the group consisting of Ca, Sr, Ba, Nd and Li,
$M^2$ is at least one kind of element species constituting the B-site selected from the group consisting of Y, Dy, Ho, Er, Tm, Yb and Lu,
$M^3$ is at least one kind of element species constituting the B-site selected from the group consisting of W, Nb and Sb, and
a, b, c, x, y and $\alpha$ are expressed by the following conditions:

$0.98 \leqq y \leqq 1.01$ and, particularly, $0.992 \leqq y \leqq 1.007$,
$0.01 \leqq a \leqq 0.1$ and, particularly, $0.03 \leqq a \leqq 0.08$,
$0.005 \leqq b \leqq 0.025$ and, particularly, $0.008 \leqq b \leqq 0.02$,
$0.005 \leqq c \leqq 0.015$ and, particularly, $0.006 \leqq c \leqq 0.009$,
$0.45 \leqq x \leqq 0.55$ and, particularly, $0.47 \leqq x \leqq 0.53$,
$-0.03 \leqq \alpha \leqq 0.02$, particularly, -0.02 to 0.01 and,

most desirably, -0.01 to 0.005.

That is, upon partly substituting Pb in the A-site of the perovskite composite oxide with the element $M^1$ and upon partly substituting Zr and Ti in the B-site with elements $M^2$ and $M^3$, the Curie temperature and the effective piezoelectric distortion constant can be further enhanced to further improve the durability and reliability against high temperatures. From the standpoint of adjusting the average valency of the piezoelectric ceramic and increasing the Curie temperature and the effective piezoelectric distortion constant, it is desired to use at least one kind of Ca, Sr and Ba as the element $M^1$ (element constituting the A-site) and, more desirably, to use both Sr and Ba as the element $M^1$. In this case, an optimum element ratio of Sr and Ba is in a range of Sr:Ba = (1.5 to 2.5):(2.5 to 3.5). As the element $M^2$ (one element constituting the B-site), it is particularly desired to use Yb and as the element $M^3$ (another element constituting the B-site), it is particularly desired to use W.

Further, the parameters a, b, c, x, y and $\alpha$ representing the amounts of the above elements, most desirably, assume values within the above-mentioned ranges from the standpoint of adjusting the average valency of the piezoelectric ceramic, increasing the Curie temperature and the effective piezoelectric distortion constant and enhancing the durability against high temperatures.

Further, so far as the value of the parameter y representing the element ratio A/B of the element species of the A-site and the element species of the B-site lies within the above range, the Curie temperature and the effective piezoelectric distortion constant can be very effectively increased, a drop in the output can be suppressed to be not larger than 10% in the durability testing at high temperatures of up to $10^9$ cycles, and the firing can be realized at a low temperature. When, for example, the value y representing the ratio (A/B) is smaller than the above range, it becomes difficult to increase the density through the firing at a low temperature that will be described later. When the value y of (A/B) becomes greater than the above range, on the other hand, there tends to take place delamination.

It is further desired that the piezoelectric ceramic of the present invention has an average grain size of 1 to 6 $\mu$m and, particularly, 1.5 to 2.5 $\mu$m from the standpoint of enhancing the piezoelectric characteristics and improving the mechanical strength.

By setting the value of parameter $\alpha$ representing an excess amount of oxygen to lie within the above range as represented by the above formula (2), further, there is obtained an advantage of further highly stabilizing the piezoelectric characteristics and mechanical strength of the piezoelectric ceramic.

As described above, the piezoelectric ceramic of the present invention contains the perovskite composite oxide as a main crystal phase and, desirably, contains almost no different phase. The piezoelectric ceramic of the invention may inevitably contain Ag, Al, Fe, S, Cl, Eu, K, P, Cu, Mg and Si without, however, posing any problem from the standpoint of characteristics.

(Production of Piezoelectric Ceramic)

The above piezoelectric ceramic is produced by preparing a starting powder of a predetermined composition, calcining the starting powder, and molding and firing the calcined body.

The starting powder is a mixture of a powder of the starting compound for the A-site and a powder of the starting compound for the B-site. As the starting compound for the A-site, there can be used a Pb oxide and, as required, an oxide or a carbonate of the above-mentioned element $M^1$. As the starting compound for the B-site, there can be used a Zr oxide ($ZrO_2$), a Ti oxide ($TiO_2$) and, as required, oxides or carbonates of the above-mentioned elements $M^2$ and $M^3$. Though there are various Pb oxides that can be used as the starting compound for the A-site, it is desired to use $Pb_3O_4$ from such a standpoint that it can be finely pulverized with ease, remains stable for a variety of solvents that will be described later, does not permit the composition thereof to vary, and can be easily adjusted for its composition. As described already, these starting compounds are so mixed that the average valency of element species constituting the B-site lies within the above-mentioned range and that the composition ratios of the formula (2) described above are satisfied.

It is further desired that the above starting powder is adjusted to be a fine powder having an average grain size $D_{50}$ of not larger than 0.8 $\mu$m to be effectively fired at a low temperature of 1000°C or lower. The fine pulverization can be conducted by using, for example, a vibration mill, Atritor or a ball mill. In particular, it is desired to conduct the fine pulverization by wet-milling by using a ball mill containing, particularly, spherical balls of a diameter of not larger than 5 mm. As the material of the ball, it is desired to use zirconia since it is capable of suppressing impurities from mixing and of suppressing a decrease in the piezoelectric characteristics even in case the impurities are mixed stemming from the balls.

The starting powder finely pulverized as described above is, as required, dried or dehydrated and is calcined in a low temperature region of not higher than 900°C, preferably, 700 to 800°C and, more preferably, 730 to 760°C. It is desired that the calcined body that is obtained is suitably milled and adjusted for its grain size so as to have a uniform grain size distribution of an average grain size $D_{50}$ of not larger than 0.8 $\mu$m and, particularly, an integrated grain size $D_{90}$ of not larger than 0.9 $\mu$m. It is desired that the BET specific surface area thereof is not smaller than 7 $m^2$/g and, particularly, not smaller than 8 $m^2$/g due to the milling. That is, as a result of finely pulverizing the starting powder, the calcined body needs be milled only slightly (milled to an extent of digesting the aggregate) to adjust the grain size and, hence, to maintain a high reactivity, making it possible to obtain the piezoelectric ceramic having the above-mentioned characteristics through the firing at a low temperature of 1000°C or lower. For example, when the calcined body is strongly milled as is usually done, excess of shock and heat are imparted to the powder of before being fired making it difficult to obtain the piezoelectric ceramic having the above-mentioned characteristics through the firing at 1000°C or lower.

Next, a powder of the calcined body of which the grain size is adjusted as described above is molded into a predetermined shape. The molding is conducted by using means known per se. For example, the calcined powder is mixed into an organic binder such as of an acrylic resin and is, as required, mixed with a solvent such as water or an alcohol and a plasticizer to prepare a slurry for molding. By using molding means such as a doctor blade method or an extrusion-molding method, the slurry is molded into a predetermined shape.

After the binder is removed, the above molded body is fired to obtain a piezoelectric ceramic having the above-mentioned characteristics. The binder is removed by heating at a temperature of about 300 to about 400°C for about 5 to about 40 hours. In the present invention, the firing may be conducted in a low temperature region of not higher than 1000° and, particularly, at 950 to 1000° for about 2 to 5 hours. Through the firing at such a low temperature, there is obtained a piezoelectric ceramic which is dense and having excellent characteristics as described above.

(Laminated Piezoelectric Element).

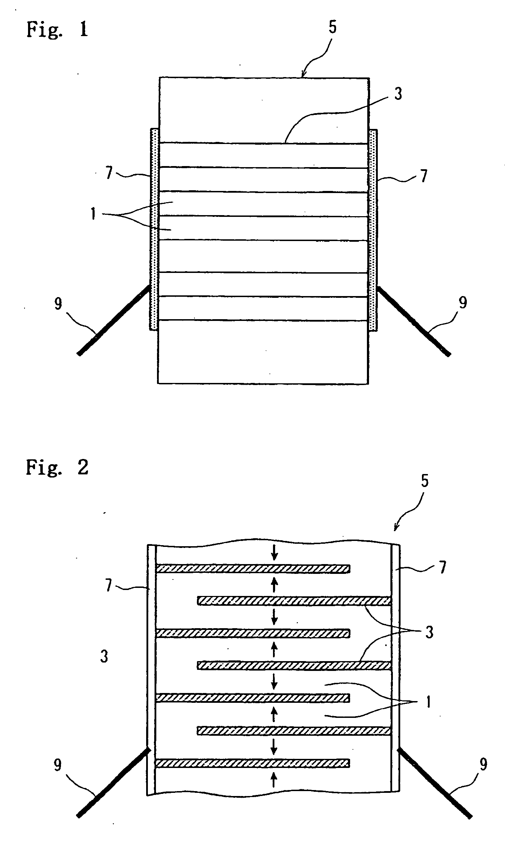

The above piezoelectric ceramic can be very effectively used, particularly, as an element for constituting the laminated piezoelectric element. Fig. 1 is a view schematically illustrating the structure of an exemplary laminated piezoelectric element, and Fig. 2 is a view illustrating, on an enlarged scale, a major portion thereof.

In Figs. 1 and 2, the laminated piezoelectric element has a laminate (element body) 5 obtained by alternately laminating a plurality of piezoelectric layers 1 and internal electrode layers 3. External electrode plates 7, 7 are connected to different side surfaces of the element body 5, and lead wires 9 are connected to the external electrode plates 7, 7 serves as a positive electrode and the other one serves as a negative electrode).

As will be understood from fig. 2, further, the neighboring internal electrode layers 3 are connected to different external electrode plates 7. When a predetermined voltage is applied to the external electrode plates 7, 7, therefore, electric fields of opposite directions are applied to the neighboring piezoelectric layers 1, 1.

In the laminated piezoelectric element, the piezoelectric layers 1 are constituted by using the piezoelectric ceramic of the invention described above, each having a thickness in a range of 0.05 to 0.25 mm. In the piezoelectric layers 1, the ceramic has an average grain size of, usually, in a range of 1 to 6 $\mu$m as described above. It is, however, desired that the ceramic has an average grain size of not smaller than 1.5 $\mu$m and, particularly, not smaller than 2 $\mu$m from the standpoint of enhancing the piezoelectric characteristics, and has an average grain size of not larger than 4 $\mu$m and, particularly, not larger than 3 $\mu$m from the standpoint of enhancing the mechanical strength. The average grain size of the ceramic will be controlled depending upon the starting powder described above and upon the average grain size of the calcined body.

It is desired that the internal electrode layers 3 each have a thickness of 0.003 to 0.01 mm, and that the numbers of the piezoelectric layers 1 and the internal electrode layers 3 are each 100 to 400 to obtain desired characteristics. Further, the laminated piezoelectric element (element body 5) may have any shape such as a square pole, a hexagonal pole or a cylindrical pole but desirably has the shape of a square pole from the standpoint of easy cutting.

In the laminated piezoelectric element, the internal electrode layers 3 may be formed by using various metals, e.g., noble metals such as Ag, Pd or Pt, or base metals such as Cu or Ni. From the standpoint of maintaining a high electric conduction and a low cost, however, it is particularly desired that the content of Ag is not smaller than 85% by mass, particularly, not smaller than 90% by mass and, most desirably, not smaller than 95% by mass with respect to the whole metals. The internal electrode layers 3 containing Ag in large amounts can be fired at a low temperature. The above-mentioned ceramic can be formed by firing in a low temperature region of 950 to 1000°C. Therefore, the piezoelectric layers 1 and the internal electrode layers 3 can be co-fired, which is a great advantage of the invention.

When the internal electrode layers 3 contain Ag in large amounts as described above, ionic migration of Ag may easily occur at the time of firing. The ionic migration, however, can be suppressed by containing Pt in an amount of not smaller than 0.1% by mass in the internal electrode layers 3. Further, the ionic migration can be suppressed by using Ag and Pd in combination. In this case, the Pd content is desirably about 5 to 20% by mass.

The laminated piezoelectric element can be produced in compliance with the above-mentioned method of producing the piezoelectric ceramic.

That is, relying upon the method described above, a slurry for molding is prepared by using the calcined starting powder. By using this slurry, there is prepared a green sheet for piezoelectric layers 1.

An electrically conducting paste prepared by mixing the above conducting components such as Ag, Pd or Pt and an organic binder or a solvent, is printed onto one surface of the green sheet by a screen-printing method to form a conducting pattern corresponding to the internal electrode layers 3. After the conducting pattern is dried, a plurality of green sheets forming the conducting patterns are laminated in a predetermined number of pieces. Thereafter, green sheets without electrically conducting paste are laminated on the uppermost layer and on the lowermost layer of the laminate to fabricate a pole-like laminate corresponding to the element body 5.

Next, the pole-like laminate is integrated by heating at 50 to 200°C under the application of a pressure, is cut into a predetermined size and, after the binder is removed, is fired at a low temperature (950 to 1000°C) to obtain a laminated sintered body that becomes the element body 5 as described above in connection with the method of producing the piezoelectric ceramic.

Ends of the internal electrode layers 2 are exposed on the side surfaces of the thus obtained element body (laminated sintered body) 5. Therefore, the ends of every other internal electrode layers 2 are ground in the predetermined two side surfaces of the element body 5 to form grooves. The grooves formed in one side surface and the grooves formed in the other side surface are alternate to each other. These grooves, usually, have a depth of about 50 to about 150 $\mu$m and have a width (length in the direction of lamination) of about 50 to about 100 $\mu$m.

The thus formed grooves are, as required, filled with an insulator such as a silicone rubber, and the external electrode plates are stuck to the side surfaces forming the grooves by using an adhesive or the like. Therefore, the one external electrode plate 7 and the other external electrode plate 7 are connected to the ends of different internal electrode layers 3 in an alternate manner.

Thereafter, lead wires 9 are connected to the external electrode plates 7, 7 to obtain a laminated piezoelectric element of a structure shown in Figs. 1 and 2. The laminated piezoelectric element is coated over the outer peripheral surfaces thereof with a silicone rubber by such a method as dipping, and is put to the polarization treatment by applying a polarizing electric field of 3 kV/mm, and is finally used as a piezoelectric actuator.

The above laminated piezoelectric element can be produced by co-firing the piezoelectric layers and the internal electrode layers having a high Ag ratio, and exhibits a high Curie temperature and a high effective piezoelectric distortion constant in compliance with the characteristics of the piezoelectric ceramic that constitutes the piezoelectric layers, and features excellent durability and reliability against high temperatures. The laminated piezoelectric element is useful as an injection device for media such as fuels and gases. The injection device contains the laminated piezoelectric element of the above-mentioned structure in a container that has, for example, an injection hole, and is equipped with a valve for injecting a liquid from the injection hole when the laminated piezoelectric element is driven.

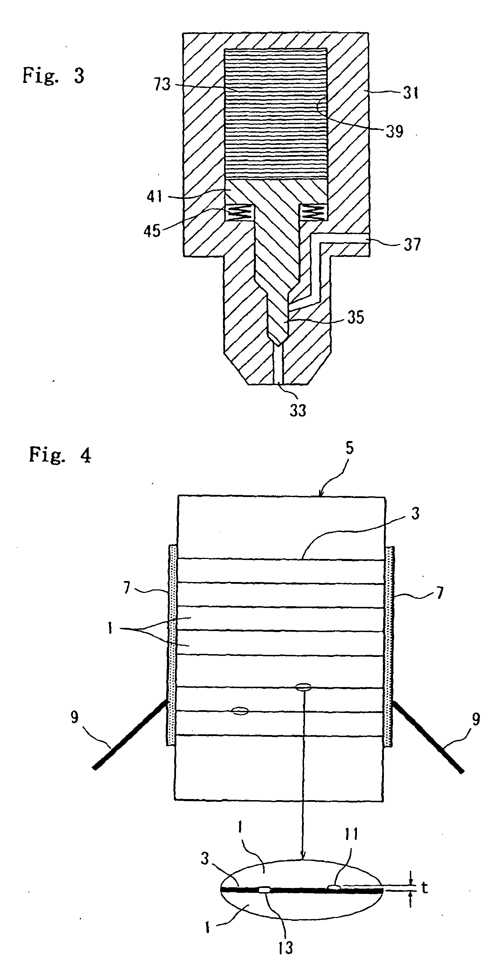

A constitution of the above injection device is shown in Fig. 3, wherein a laminated piezoelectric element (piezoelectric actuator) 43 of the above-mentioned structure is contained in a cylinder 39 of a container 31.

An injection hole 33 is formed at an end of the container 31, and a needle valve 35 is contained in the container 31 to open and close the injection hole 33.

A fuel passage 37 is communicated with the injection hole 33 in a manner to be interrupted by the needle valve 35. The fuel passage 37 is communicated with an external fuel supply, and a fuel is fed to the fuel passage 37 at all times maintaining a predetermined high pressure. That is, when the needle valve 35 permits the injection hole 33 to be opened, the fuel supplied to the fuel passage 37 is injected into a combustion chamber (not shown) of an internal combustion engine with the predetermined high pressure.

Further, an upper end of the needle valve 35 has a large diameter, is continuous to a piston 41 which can slide in the cylinder 39, and the piston 41 is urged upward by an initially coned disc spring 45 and is coupled to the piezoelectric actuator 43 contained in the cylinder 39.

In this injection device, when the piezoelectric actuator 43 extends due to the application of a voltage, the piston 41 is pushed, the needle valve 35 closes the injection hole 33, and the supply of fuel is interrupted. When the application of voltage discontinues, further, the piezoelectric actuator 43 contracts, the initially coned disc spring 45 pushes the piston 41 back, and the injection hole 33 is communicated with the fuel passage 37 permitting the fuel to be injected.

The injection device employs the above-mentioned laminated piezoelectric element of high performance fabricated at a low cost as the actuator which is the heart of the device. Therefore, the present invention makes it possible to enhance performance of the injection device and to decrease its cost.

Further, the laminated piezoelectric element of the invention can be designed in a variety of ways. For example, gaps can be locally formed in the interfaces among the piezoelectric layers 1 and the internal electrode layers 3 to thereby greatly enhance the amount of displacement of the laminated piezoelectric element.

Fig. 4 illustrates the structure of the laminated piezoelectric element forming the above gaps. As shown in Fig. 4, the laminated piezoelectric element has a basic structure which is the same as that of the laminated piezoelectric element shown in Fig. 1 that was described above, but has partial gaps 11 in the interfaces among the piezoelectric layers 1 and the internal electrode layers 3.

That is, prior to the use, a voltage is applied across the external electrode plates 7, 7 and a polarizing electric field (3 kV/mm) is applied to the piezoelectric layers 1 to polarize the laminated piezoelectric element. The polarization treatment is usually conducted by locking the element body 5 in a direction in which it is to be compressed by applying a load. Therefore, the piezoelectric layers 1 are held in a state of being clamped by the internal electrode layers 3, and the junction strength is enhanced among the above layers. In the laminated piezoelectric element produced by co-firing, in particular, the piezoelectric layers 1 and the internal electrode layers 3 are tightly and intimately contacted together greatly enhancing the junction strength among the piezoelectric layers 1 and the internal electrode layers 3. However, as the junction strength increases among the piezoelectric layers 1 and the internal electrode layers 3, the piezoelectric layers 1 in contact with the internal electrode layers 3 are suppressed from displacing in the direction of surface thereof. As a result, the piezoelectric layers 1 are suppressed from displacing in the direction of thickness thereof (direction of height of the element body 5), too, resulting in a decrease in the amount of displacement of the laminated piezoelectric element itself. In the embodiment of Fig. 4, however, clamping of the piezoelectric layers 1 by the internal electrode layers 3 is relaxed by the formation of gaps 11 suppressing an increase in the adhering strength among the layers. Therefore, the amount of displacement of the laminated piezoelectric element can be increased.

The above-mentioned gaps 11 can be formed through a suitable degree of treatment in an electric field under the application of no pressure prior to the above-mentioned polarization treatment. That is, the treatment in the electric field consists of suitably vibrating the piezoelectric layers 1 by applying an electric field of a suitable degree to the external electrode plates 7, 7 causing the surfaces of the internal electrode layers 3 to be partly separated away from the surfaces of the piezoelectric layers 1 and, at the same time, causing the surfaces of the internal electrode layers 3 to partly bite into dents in the surfaces of the piezoelectric layers 1. Therefore, gaps 11 of a suitable size are partly formed to decrease the junction strength by a suitable degree. The treatment in the electric field can be conducted by applying any one of a DC voltage, an AC voltage or a pulse voltage to the external electrode plates 7, 7. To lower the junction strength by a suitable degree while preventing the layers from exfoliating to a large extent, however, it is desired to apply the DC voltage. From the standpoint of lowering the junction strength by a suitable degree and maintaining a large electrostatic capacity of the piezoelectric layers 1, however, it is desired to apply a voltage of not higher 200 V, preferably, not higher than 150 V but not lower than 50 V to maintain a suitable degree of junction strength. The time for treatment in the electric field may differ depending upon the voltage that is applied but is, usually, not shorter than 30 seconds and, particularly, from about 10 to about 180 seconds. Further, when the treatment in the electric field is conducted by applying the AC voltage, the frequency thereof is, desirably, not higher than 1 kHz. To effectively conduct the treatment in the electric field, further, it is desired that the treatment is conducted in an atmosphere of a relative humidity (RH) which is not lower than 40%.

To effectively lower the junction strength by the above treatment in the electric field, further, it is desired that the thickness of the internal electrode layers 3 is set to be not larger than 10 $\mu$m.

It is further desired that the electrically conducting paste for forming the internal electrode layers 3 does not exhibit blending property to the green sheet that is forming the piezoelectric layers 1 from the standpoint of suppressing the junction strength. Concretely speaking, the solvent or the binder used for the electrically conducting paste should be the one different from the solvent or the binder used for forming the green sheet. The poorer the affinity between them, the more the components constituting the piezoelectric layers 1 are suppressed from infiltrating into the internal electrode layers 3 during the firing. Therefore, the spot-like cavities 13 tend to be formed in the internal electrode layers 3. As a result, the adhesion strength can be suppressed to be low among the piezoelectric layers 1 and the internal electrode layers 3 making it possible to increase the amount of displacement of the laminated piezoelectric element.

In the present invention, the gaps 11 partly formed among the piezoelectric layers 1 and the internal electrode layers 3 as described above, have a width t of not larger than 1 $\mu$m in the direction of thickness. In particular, the gaps 11 having a small thickness t can be confirmed by observing the interfaces of the layers by using a microscope.

In the thus laminated piezoelectric element, it is desired that the number of the laminated layers (total number of the piezoelectric layers 1 and the internal electrode layers 3) is not smaller than 100 from the standpoint of increasing the amount of displacement. From the standpoint of reducing the weight, further, it is desired that each piezoelectric layer 1 has a thickness of not larger than 300 $\mu$m and, particularly, not larger than 100 $\mu$m.

The above laminated piezoelectric element is useful as a laminated piezoelectric actuator, as well as for such applications as a laminated piezoelectric transformer, a laminated capacitor and the like.

(EXAMPLES)

The invention will now be described by way of the following Experiments.

(Experiment 1)

Starting powders for piezoelectric ceramics were prepared by weighing the powders of $Pb_3O_4$, $ZrO_2$, $TiO_2$, $BaCO_3$, $SrCO_3$, $WO_3$ and $Yb_2O_3$ of high purities in predetermined amounts, and wet-mixing the powders in a ball mill having zirconia balls of a diameter of 5 mm for 20 hours. In the starting powders, $BaCO_3$ and $SrCO_3$ were used at a mol ratio of 3:2 as the element $M^1$ of the A-site in the following formula (1),

$$[Pb_{y-a}M^1{}_a] \cdot [M^2{}_b M^3{}_c (Zr_{1-x}Ti_x)_{1-b-c}] \cdot O_{3+\alpha} \qquad (1)$$

and a was selected to be 0.05. As the element $M^2$ and element $M^3$ of the B-site, there were used $WO_3$ and $Yb_2O_3$, respectively, and average valencies of the B-site were set to be as shown in Table 1. In this Experiment, the average valency of the A-site was set to be 2, and the ratio A/B was set to be 1.

The above starting powders were dehydrated, dried, calcined at 750°C for 3 hours, and were pulverized to adjust average grain sizes ($D_{50}$) of the calcined bodies to be not larger than 0.8 $\mu$m and BET specific surface areas to be not smaller than 8 $m^2$/g. There was obtained calcined powders for producing the piezoelectric ceramics and the laminated piezoelectric elements of the present invention.

First, to evaluate the densities of the piezoelectric ceramics only, molded bodies having a diameter of 10 mm and a thickness of 1 mm were prepared by using the above calcined powders and were fired at 1000°C (the slurries used for forming the molded bodies possessed the same compositions as those used for forming the actuators that will be described below). The piezoelectric ceramics were measured for their densities and grain sizes. The samples having relative densities of not higher than 95% were regarded to be of low densities and to be defective. The ceramic samples having polished cross sections were measured for their grain sizes by using an electron microscope.

Further, the above calcined powders, an acrylic resin binder and a plasticizer (dibutyl phthalate: DBP) were mixed together to prepare slurries from which ceramic green sheets of a thickness of 150 $\mu$m were prepared by a slip-casting method. A conducting paste comprising Ag-Pd as a chief component and having an Ag/Pd ratio as shown in Table 1 was printed onto the surfaces on one side of the green sheets maintaining a thickness of 5 $\mu$m by a screen-printing method, and was dried. Two hundred pieces of the green sheets were laminated, and 10 pieces of green sheets without coated with the conducting paste were laminated on both the upper end and the lower end of the laminates.

Next, the laminates were integrated by the application of a pressure while being heated at 100°C. The laminates were cut into a size of 12 mm x 12 mm and, thereafter, the binder was removed therefrom at 800°C for 10 hours, and were fired at 950 to 1000°C for 2 hours to obtain laminated sintered bodies that could be used as the actuator bodies.

External electrode plates (positive electrode plate and negative electrode plate) were formed on the two side surfaces of the laminated sintered bodies so as to alternately meet the ends of the internal electrodes included in the piezoelectric ceramics along the two side surfaces. Thereafter, the lead wires were connected to the positive electrode plate and to the negative electrode plate, and the outer peripheral surfaces were coated with a silicone rubber by dipping followed by the application of a polarizing voltage of 3 kV/mm to effect the polarization treatment thereby to obtain laminated piezoelectric elements.

The thus obtained laminated piezoelectric elements were evaluated for their effective piezoelectric distortion constants, Curie temperatures and durability against high temperatures.

The effective piezoelectric distortion was evaluated by applying a voltage of 0 to 200 V in a state where pre-load of 150 kgf has been applied in a direction of lamination to the samples fixed onto a vibration-proof plate, measuring the amounts of change in the overall length of the samples, and dividing the amounts of change by the number of the laminated layers and by the applied voltage.

The Curie temperatures were found by measuring the temperature characteristics of electrostatic capacities of the piezoelectric ceramics.

The durability testings against high temperatures were evaluated by repetitively driving the samples up to $10^9$ times in a constant-temperature vessel under the conditions of a temperature of 150°C and a frequency of 50 Hz being applied with a load of 150 kgf.

For comparison, the samples (Nos. 1, 7) having average valencies of the B-site lying outside the range of the present invention were similarly evaluated.

Table 1

| Sample No. | Average valency of B-site | Amount of $M^2$ (mol) b | Amount of $M^3$ (mol) c | Ti/ (Zr+Ti) ratio X | Ag/Pd | Effective piezoelectric distortion consyants $d_{33}$ pm/V | Curie temp. (°C) | Durability to hi-temp. $10^9$ cycles |
|---|---|---|---|---|---|---|---|---|
| *1 | 3.994 | 0.010 | 0.0020 | 0.475 | 95/5 | 690 | 335 | ○ |
| 2 | 4.002 | 0.010 | 0.0060 | 0.485 | 95/5 | 860 | 331 | ○ |
| 3 | 4.004 | 0.010 | 0.0070 | 0.485 | 95/5 | 865 | 330 | ◎ |
| 4 | 4.005 | 0.010 | 0.0075 | 0.480 | 95/5 | 930 | 328 | ◎ |
| 5 | 4.006 | 0.010 | 0.0080 | 0.485 | 95/5 | 868 | 328 | ◎ |
| 6 | 4.008 | 0.010 | 0.0090 | 0.490 | 95/5 | 870 | 325 | ○ |
| *7 | 4.014 | 0.010 | 0.0120 | 0.495 | 95/5 | 630 | 320 | ○ |
| 8 | 4.002 | 0.010 | 0.0060 | 0.485 | 90/10 | 889 | 331 | ○ |
| 9 | 4.004 | 0.010 | 0.0070 | 0.485 | 90/10 | 894 | 331 | ◎ |
| 10 | 4.005 | 0.010 | 0.0075 | 0.480 | 90/10 | 961 | 329 | ◎ |
| 11 | 4.006 | 0.010 | 0.0080 | 0.485 | 90/10 | 897 | 328 | ◎ |
| 12 | 4.008 | 0.010 | 0.0090 | 0.490 | 90/10 | 899 | 326 | ○ |
| 13 | 4.002 | 0.010 | 0.0060 | 0.485 | 85/15 | 908 | 331 | ○ |
| 14 | 4.004 | 0.010 | 0.0070 | 0.485 | 85/15 | 913 | 330 | ◎ |
| 15 | 4.005 | 0.010 | 0.0075 | 0.480 | 85/15 | 982 | 328 | ◎ |
| 16 | 4.006 | 0.010 | 0.0080 | 0.485 | 85/15 | 916 | 329 | ◎ |
| 17 | 4.008 | 0.010 | 0.0090 | 0.490 | 85/15 | 918 | 326 | ○ |

Marks * represent samples lying outside the scope of the present invention.

** ◎ represents a drop of not larger than 10% in the amount of displacement after $10^9$ cycles.

From the results of Table 1, the samples Nos. 2 to 6 and 8 to 17 which were the laminated piezoelectric elements of the invention all possessed relative densities of ceramics of not smaller than 95% and average grain sizes of 1 to 6 μm. These samples, further, exhibited the Curie temperatures of not lower than 325°C, effective piezoelectric constants of not smaller than 860 pm/V, and none of them were regarded to be defective in the testing of durability against high temperatures, i.e., in the operation testing of up to $10^9$ cycles.

In particular, the samples Nos. 3 to 5, 9 to 11, and 14 to 16 having an average grain size of piezoelectric ceramics of 2 μm exhibited Curie temperatures of not lower than 328°C, effective piezoelectric distortion constants of not smaller than 865 pm/V and drops in the amount of displacement of not larger than 10% in the durability testing against high temperatures of up to $10^9$ cycles.

On the other hand, the samples Nos. 1 and 7 lying outside the scope of the invention exhibited low effective piezoelectric distortion constants and drops in the amount of displacement of not smaller than 10% in the durability testing against high temperatures.

(Experiment 2)

As the starting powder, first, there was used a calcined powder of the composition same as the sample No. 3 of Experiment 1.

The calcined powder, an organic binder (polyvinyl butyral) and a plasticizer (DBP) were mixed together to prepare a slurry from which a ceramic green sheet of a thickness of 100 $\mu$m was prepared by the slip-casting method. The ceramic green sheet was cut into a desired size, and a conducting paste was printed onto one surface thereof by the screen-printing method such that the thickness thereof was 5 $\mu$m and the effective area of the electron pattern was 90% that of the ceramic green sheet after it has been cut.

The conducting paste was prepared by adding an organic binder (ethyl cellulose) and a plasticizer to a mixed powder of Ag/Pd = 95/5 (% by mass). For some samples, the starting powder for the piezoelectric ceramic used for forming the green sheet was mixed in an amount of 3% by weight as a base material.

Next, the conducting pattern was dried, and 200 pieces of the green sheets on which the conducting pattern has been formed were laminated, and 10 pieces of green sheets without coating with the conducting paste were laminated on both the upper end and the lower end of the laminate.

Next, the laminate was pressed while being heated at 100°C to obtain a laminated sintered body that could be used as the actuator body in quite the same manner as in Experiment 1. External electrode plates and lead wires were connected thereto, and the outer peripheral surfaces were coated with a silicone rubber by dipping to obtain a laminated piezoelectric element.

The thickness of piezoelectric layers of the thus obtained laminated piezoelectric element was 80 $\mu$m on an average, and the thickness of the internal electrode layers was 2.5 $\mu$m on an average. The whole thickness was 25 mm.

The piezoelectric element was treated in an electric field shown in Table 2 at a humidity of 50%RH and was, then, subjected to the polarization treatment by applying a polarizing voltage of 3 kV/mm. Here, however, the sample No. 1 was not treated in the electric field. In the samples treated in the electric field, the internal electrode layers were partly biting into the recessed portions of the piezoelectric layers as observed by using an electron microscope.

The laminated piezoelectric elements fabricated as described above were evaluated for their changes in the electrostatic capacity when an electric field was applied thereto and for their amounts of displacement relying on the methods described below. The results were as shown in Table 2. Each testing was conducted by using the samples in a number of 50.

Changes in the electrostatic capacity were measured by using an impedance analyzer under the conditions of a frequency of 1 kHz and 1 V.

The amounts of displacement were measured by applying a DC voltage of 200 V for 60 seconds.

Further, the piezoelectric elements were cut in a vertical direction, and the cut surfaces were observed by using a microscope (magnification of 200 times) to judge the presence of partial gaps (opening portions) among the internal electrode layers and the piezoelectric layers. The results were as shown in Table 2 (gaps of not larger than 1 $\mu$m were observed in the samples that were treated in the electric field).

Table 2

| Sample No. | Conducting paste contains material | Treated in electric field | Kind of electric field | Voltage (V) | Time (sec) | Gap | Change in capacity (%) | Amount of displacement ($\mu$m) |
|---|---|---|---|---|---|---|---|---|
| *1 | yes | no | - | - | - | no | 0 | 25 |
| 2 | yes | yes | DC | 100 | 100 | yes | 90 | 40 |
| 3 | yes | yes | DC | 50 | 100 | yes | 97 | 40 |
| 4 | yes | yes | DC | 150 | 100 | yes | 82 | 37 |
| 5 | yes | yes | DC | 100 | 300 | yes | 88 | 39 |
| 6 | yes | yes | AC** | 100 | 100 | yes | 82 | 30 |
| 7 | yes | yes | pulse *** | 100 | 100 | yes | 80 | 30 |
| 8 | yes | yes | DC | 200 | 100 | yes | 75 | 35 |
| 9 | no | yes | DC | 100 | 100 | yes | 90 | 37 |

A mark * represents a sample lying outside the scope of the present invention.
A mark ** represents a frequency of 1 Hz.
A mark *** represents a duty of 0.5 sec/0.5 sec.

From the results of Table 2, the sample No. 1 that was subjected to the polarization treatment without being treated in the electric field exhibited the amount of displacement of 25 $\mu$m. On the other hand, the samples Nos. 2 to 9 that were subjected to the polarization treatment after having been treated in the predetermined electric field exhibited the amounts of displacement of not smaller than 30 $\mu$m. In particular, the samples Nos. 2 to 5, 8 and 9 that were treated in an electric field by the application of a DC voltage of 50 to 150 V exhibited the amounts of displacement of not smaller than 35 $\mu$m.

**Claims**

1. A laminated piezoelectric element comprising a laminate (5) obtained by alternately laminating a plurality of piezoelectric layers (I) and a plurality of internal electrode layers (3), said piezoelectric layers (1) being constituted by a piezoelectric ceramic comprising a perovskite composite oxide of an $ABO_3$ composition containing Pb in the A-site and Zr and Ti in the B-site, wherein when the total amount of the element species constituting the B-site of the perovskite composite oxide in the ceramic is set to be one mol, an average valency of the element species constituting the B-site is in a range of from 4.002 to 4.009;
**characterised in that** the element further comprises partial gaps (11) in the interfaces among the piezoelectric layers (1) and the internal electrode layers (3).

2. A laminated piezoelectric element according to claim 1, wherein the piezoelectric ceramic contains the constituent element species of the perovskite composite oxide in such amounts that satisfy the molar ratios expressed by the following formula,

$$[Pb_{y-a}M^1_a] \cdot [M^2_b M^3_c (Zr_{1-x}Ti_x)_{1-b-c}] \cdot O_{3+\alpha}$$

wherein is at least one kind of element species constituting the A-site selected from the group consisting of Ca, Sr, Ba, Nd and Li,
$M^2$ is at least one kind of element species constituting the B-site selected from the group consisting of Y, Dy, Ho, Er, Tm, Yb and Lu,
$M^3$ is at least one kind of element species constituting the B-site selected from the group consisting of W, Nb and Sb, and conditions:
a, b, c, x, y and $\alpha$ are expressed by the following conditions:

$$0.98 \leqq y \leqq 1.01$$

$$0.01 \leqq a \leqq 0.1$$

$$0.005 \leqq b \leqq 0.025$$

$$0.005 \leqq c \leqq 0.015$$

$$0.45 \leqq x \leqq 0.55$$

$$-0.03 \leqq \alpha \leqq 0.02.$$

3. A laminated piezoelectric element according to claim 1, wherein the surfaces of the internal electrode layers (3) partly bite into dents in the surfaces of the piezoelectric layers (1).

4. A laminated piezoelectric element according to claim 1, wherein an electrically conducting paste for forming the internal electrode layers (3) does not exhibit blending property to green sheets that form the piezoelectric layers (1).

5. A laminated piezoelectric element according to claim 4, wherein a solvent or a binder used for the electrically conducting paste is different from a solvent or a binder used for forming the green sheets.

**6.** A method of manufacturing a laminated piezoelectric element, comprising:

obtaining a laminate (5) by laminating a plurality of piezoelectric layers (1) and a plurality of internal electrode layers (3) alternatively;
conducting a polarization treatment to the piezoelectric layers (1);
the piezoelectric layers (1) being constituted by a piezoelectric ceramic comprising a perovskite composite oxide of an $ABO_3$ composition containing Pb in the A-site and Zr and Ti in the B-site, wherein when the total amount of the element species constituting the B-site of the perovskite composite oxide in the ceramic is set to be one mol, an average valency of the element species constituting the B-site is in a range of from 4.002 to 4.009;
**characterised in that** the method further comprises the step of treating the piezoelectric layers (1) in an electric field in a no-load state prior to the polarization treatment to form partial gaps in the interfaces among the piezoelectric layers (1) and the internal electrode layers (3).

**7.** A method of manufacturing a laminated piezoelectric element according to claim 6, wherein the polarization treatment is conducted by locking the laminate (5) in a direction in which it is to be compressed by applying a load.

**Patentansprüche**

**1.** Laminiertes piezoelektrisches Element, umfassend: ein Laminat (5), erhalten durch abwechselndes Laminieren einer Mehrzahl von piezoelektrischen Schichten (1) und einer Mehrzahl innerer Elektrodenschichten (3), wobei die piezoelektrischen Schichten (1) aufgebaut sind durch eine piezoelektrische Keramik, umfassend ein Perovskit-Verbundoxid einer $ABO_3$-Zusammensetzung, enthaltend Pb an der A-Stelle und Cr und Ti an der B-Stelle, wobei die Gesamtmenge der Elementspezies, die die B-Stelle des Perovskit-Verbundoxids in der Keramik ausmacht, auf ein Mol festgelegt ist, und die Durchschnittsvalenz der Elementspezies, die die B-Stelle ausmacht, in einem Bereich von 4,002 bis 4,009 liegt; dadurch charakterisiert, dass das Element des weiteren teilweise Lücken (11) in den Grenzflächen zwischen den piezoelektrischen Schichten (1) und den inneren Elektrodenschichten (3) umfasst.

**2.** Laminiertes piezoelektrisches Element gemäß Anspruch 1, wobei die piezoelektrische Keramik die aufbauende Elementspezies des Perovskit-Verbundoxids in Mengen enthält, die den molaren Verhältnissen, ausgedrückt durch die folgende Formel, genügen:

$$[Pb_{y-a}M^1{}_a]\cdot[M^2{}_b M^3{}_c (Zr_{1-x}Ti_x)_{1-b-c}]\cdot O_{3+\alpha}$$

wobei $M^1$ mindestens eine Art einer Elementspezies ist, die die A-Stelle ausmacht, ausgewählt aus der Gruppe, bestehend aus Ca, Sr, Ba, Nd und Li, $M^2$ ist mindestens eine Art einer Elementspezies, die die B-Stelle ausmacht, ausgewählt aus der Gruppe, bestehend aus Y, Dy, Ho, Er, Tm, Yb und Lu, $M^3$ ist mindestens eine Art einer Elementspezies, die die B-Stelle ausmacht, ausgewählt aus der Gruppe, bestehend aus W, Nb und Sb, und a, b, c, x, y und $\alpha$ werden durch die folgenden Bedingungen ausgedrückt:

$$0.99 \leqq y \leqq 1.01$$

$$0.01 \leqq a \leqq 0.1$$

$$0.005 \leqq b \leqq 0.025$$

$$0.005 \leqq c \leqq 0.015$$

$$0.45 \leqq x \leqq 0.55$$

$$-0.03 \leqq \alpha \leqq 0.02.$$

**3.** Laminiertes piezoelektrisches Element gemäß Anspruch 1, wobei die Oberflächen der inneren Elektrodenschichten (3) teilweise in Zähne in den Oberflächen der piezoelektrischen Schichten (1) eingreifen.

**4.** Laminiertes piezoelektrisches Element gemäß Anspruch 1, wobei die elektrisch leitfähige Paste zur Bildung der inneren Elektrodenschichten (3) keine Mischbarkeit gegenüber grünen Folien, die die piezoelektrischen Schichten (1) bilden, zeigt.

**5.** Laminiertes piezoelektrisches Element gemäß Anspruch 4, wobei ein für die elektrisch leitfähige Paste verwendetes Lösungsmittel oder ein Bindemittel von einem zur Bildung der grünen Folien verwendeten Lösungsmittel oder Bindemittel verschieden ist.

**6.** Verfahren zur Herstellung eines laminierten piezoelektrischen Elements, umfassend: Erhalten eines Laminats (5) durch abwechselndes Laminieren einer Mehrzahl piezoelektrischer Schichten (1) und einer Mehrzahl innerer Elektrodenschichten (3); Ausführen einer Polarisationsbehandlung an den piezoelektrischen Schichten (1); wobei die piezoelektrischen Schichten (1) aufgebaut sind durch eine piezoelektrische Keramik, umfassend ein Perovskit-Verbundoxid einer $ABO_3$-Zusammensetzung, enthaltend Pb an der A-Stelle und Cr und Ti an der B-Stelle, wobei die Gesamtmenge der Elementspezies, die die B-Stelle des Perovskit-Verbundoxids in der Keramik ausmacht, auf ein Mol festgelegt ist, und die Durchschnittsvalenz der Elementspezies, die die B-Stelle ausmacht, in einem Bereich von 4,002 bis 4,009 liegt, dadurch charakterisiert, dass das Verfahren des Weiteren den Schritt der Behandlung der piezoelektrischen Schichten (1) in einem elektrischen Feld in einem nichtgeladenen Zustand vor der Polarisationsbehandlung unter Bildung teilweiser Lücken an den Grenzflächen zwischen den piezoelektrischen Schichten (1) und den inneren Elektrodenschichten (3) umfasst.

**7.** Verfahren zur Herstellung eines laminierten piezoelektrischen Elements gemäß Anspruch 6, wobei die Polarisationsbehandlung ausgeführt wird durch Fixieren des Laminats (5) in einer Richtung, in welcher es durch Anbringen einer Last verpresst werden soll.

**Revendications**

**1.** Elément piézoélectrique stratifié, comprenant un stratifié (5) obtenu par stratification, en alternance, de plusieurs couches piézoélectriques (1) et de plusieurs couches électrodes internes (3), lesquelles couches piézoélectriques (1) sont constituées d'une céramique piézoélectrique comprenant un oxyde composite de type perovskite, de composition $ABO_3$, comprenant du plomb dans les sites A et du zirconium et du titane dans les sites B, étant entendu que, si la quantité totale des divers éléments des sites B de l'oxyde composite de type perovskite dans la céramique est fixée à 1 mole, la valence moyenne des éléments des sites B vaut de 4,002 à 4,009 ;
**caractérisé en ce qu'**il y a en outre au sein de l'élément des interstices partiels (11) au niveau des interfaces entre les couches piézoélectriques (1) et les couches électrodes internes (3).

**2.** Elément piézoélectrique stratifié, conforme à la revendication 1, dans lequel la céramique piézoélectrique contient les divers éléments constitutifs de l'oxyde composite de type perovskite en des quantités qui correspondent aux rapports molaires exprimés par la formule suivante :

$$[Pb_{y-a}M^1_a] \cdot [M^2_b M^3_c (Zr_{1-x}Ti_x)_{1-b-c}] \cdot O_{3+\alpha}$$

dans laquelle

- $M^1$ représente au moins un élément présent dans les sites A et choisi parmi les calcium, strontium, baryum, néodyme et lithium,
- $M^2$ représente au moins un élément présent dans les sites B et choisi parmi les yttrium, dysprosium, holmium, erbium, thulium, ytterbium et lutétium,
- $M^3$ représente au moins un élément présent dans les sites B et choisi parmi les tungstène, niobium et antimoine,
- et les indices a, b, c, x, y et $\alpha$ respectent les inégalités suivantes :

$0,98 \leq y \leq 1,01 ; 0,01 \leq a \leq 0,1 ; 0,005 \leq b \leq 0,025 ;$
$0,005 \leq c \leq 0,015 ; 0,45 \leq x \leq 0,55 ; -0,03 \leq \alpha \leq 0,02.$

3. Elément piézoélectrique stratifié, conforme à la revendication 1, dans lequel les surfaces des couches électrodes internes (3) s'engrènent partiellement dans des dents, dans les surfaces des couches piézoélectriques (1).

4. Elément piézoélectrique stratifié, conforme à la revendication 1, dans lequel la pâte électroconductrice employée pour former les couches électrodes internes (3) ne donne pas de mélange avec les feuilles crues qui forment les couches piézoélectriques (1).

5. Elément piézoélectrique stratifié, conforme à la revendication 4, dans lequel le solvant ou liant utilisé pour la pâte électroconductrice est différent du solvant ou liant utilisé pour former les feuilles crues.

6. Procédé de fabrication d'un élément piézoélectrique stratifié, qui comporte les étapes suivantes :

   - préparer un stratifié (5) en stratifiant en alternance plusieurs couches piézoélectriques (1) et plusieurs couches électrodes internes (3) ;
   - et soumettre les couches piézoélectriques (1) à un traitement de polarisation ;

   et dans lequel les couches piézoélectriques (1) sont constituées d'une céramique piézoélectrique comprenant un oxyde composite de type perovskite, de composition $ABO_3$, comprenant du plomb dans les sites A et du zirconium et du titane dans les sites B, étant entendu que, si la quantité totale des divers éléments des sites B de l'oxyde composite de type perovskite dans la céramique est fixée à 1 mole, la valence moyenne des éléments des sites B vaut de 4,002 à 4,009 ;
   **caractérisé en ce que** le procédé comporte en outre, avant le traitement de polarisation, une étape de traitement des couches piézoélectriques (1) dans un champ électrique, dans un état sans charge, dont le but est de former des interstices partiels dans les interfaces entre les couches piézoélectriques (1) et les couches électrodes internes (3).

7. Procédé de fabrication d'un élément piézoélectrique stratifié, conforme à la revendication 6, dans lequel on effectue le traitement de polarisation en verrouillant le stratifié (5) dans la direction selon laquelle il doit subir une compression, en appliquant une charge.

Fig. 1

Fig. 2

Fig. 3

Fig. 4

**EP 1 690 844 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002293625 A
- JP 2002299710 A
- EP 1387417 A2